# FASCICULE DE BREVET EUROPEEN

(11) **EP 3 037 835 B1**
(45) Date de publication et mention de la délivrance du brevet: **18.06.2025**
(21) Numéro de dépôt: 15196885.6
(22) Date de dépôt: 27.11.2015
(51) Int. Cl.: G01R 31/327, G01R 22/06, H01H 71/04, H01H 9/16, G01V 3/10, G01V 8/12

(54) **PROCÉDÉ DE DÉTECTION D'UNE INCOHÉRENCE ENTRE UN ÉTAT COMMANDÉ ET UN ÉTAT RÉEL D'UN ORGANE DE COUPURE**
DETEKTIONSVERFAHREN EINER INKOHÄRENZ ZWISCHEN EINEM GEFORDERTEN ZUSTAND UND EINEM REALEN ZUSTAND EINES UNTERBRECHUNGSORGANS
METHOD FOR DETECTING AN INCONSISTENCY BETWEEN A CONTROLLED STATE AND A REAL STATE OF A CUT-OFF DEVICE

(30) Priorité: 02.12.2014 FR 1461818
(43) Date de publication de la demande: 29.06.2016
(73) Titulaire: SAGEMCOM ENERGY & TELECOM SAS, 92270 Bois-Colombes (FR)
(72) Inventeur: TEBOULLE, Henri, 92270 BOIS-COLOMBES (FR); REGNAULT, Laurent, 92270 BOIS-COLOMBES (FR)
(74) Mandataire: Cabinet Boettcher

(56) Documents cités:
- EP-A1- 2 503 343
- EP-A2- 1 278 077
- FR-A1- 2 996 310
- GB-A- 2 473 013
- US-A- 5 914 664
- US-A1- 2010 259 347
- "Electricity Meters Residential Landis+Gyr E450 Advanced Residential Meter with integrated PLC modem", 1 January 2012 (2012-01-01), XP055206911, Retrieved from the Internet <URL:http://www.landisgyr.com/webfoo/wp-content/uploads/2012/09/D000028191_E450_f_en.pdf> [retrieved on 20150807]
- GORDAN STRUKLEC ET AL: "Implementing DLMS/COSEM in smart meters", ENERGY MARKET (EEM), 2011 8TH INTERNATIONAL CONFERENCE ON THE EUROPEAN, IEEE, 25 May 2011 (2011-05-25), pages 747 - 752, XP031902013, ISBN: 978-1-61284-285-1, DOI: 10.1109/EEM.2011.5953109

## Description

L'invention concerne un procédé de détection d'une incohérence entre un état commandé et un état réel d'un organe de coupure d'un compteur d'énergie électrique et la remontée par courants porteurs en ligne d'un message d'alarme associé.

### ARRIERE PLAN DE L'INVENTION

Les compteurs d'énergie électrique modernes sont des compteurs électroniques dits « intelligents » qui sont bien sûr adaptés à mesurer une quantité d'énergie électrique consommée dans une habitation ou dans un lieu quelconque et à afficher cette mesure, mais qui sont aussi capables de réaliser un certain nombre de fonctions complémentaires : gestion des tarifs par réception d'ordres, relève et programmation à distance, télé-information client, etc.

Les compteurs électriques intelligents sont organisés en de véritables réseaux de compteurs au sein desquels circulent à la fois des données transmises par les compteurs aux fournisseurs d'énergie électrique ou aux gestionnaires des réseaux et des données reçues par les compteurs. Chacun de ces réseaux comporte classiquement des ensembles de compteurs reliés chacun à un concentrateur de données qui reçoit les données issues de cet ensemble de compteurs ou à destination de cet ensemble de compteurs et qui est lui-même connecté à un ou plusieurs serveurs.

Les protocoles mis en œuvre dans les échanges de données sont notamment des protocoles de type protocole CPL (Courants Porteurs en Ligne), également nommé PLC en anglais (Power Line Communication), permettant aux compteurs de communiquer avec des serveurs ou des concentrateurs de données en utilisant les couches applicatives COSEM, DLMS sur des infrastructures de réseaux CPL.

Dans un tel réseau de compteurs, la détermination précise de l'origine des pannes ou des défauts pouvant survenir est complexe à réaliser de manière fiable, mais est fondamentale. En effet, l'un des intérêts du développement des réseaux de compteurs intelligents est de réduire au maximum les interventions d'opérateurs du fournisseur d'énergie électrique pour vérifier le bon fonctionnement des compteurs ou des concentrateurs de données. Les éléments constituant le réseau doivent donc être capables de détecter de manière autonome les pannes ou défauts et leur origine.

Les documents EP2503343A1 ainsi que FR2996310A1 divulguent des compteurs d'énergie électrique.

### OBJET DE L'INVENTION

L'invention a pour objet de mieux identifier l'origine des pannes ou des défauts dans un réseau de compteurs d'énergie électrique en améliorant la remontée de ces pannes et défauts.

### RESUME DE L'INVENTION

En vue de la réalisation de ce but, on propose un procédé de détection d'une incohérence entre un état commandé ouvert ou fermé et un état réel d'un organe de coupure d'un compteur d'énergie électrique tel que décrit dans la revendication 1.

L'organe de coupure du compteur est classiquement monté sur un conducteur de phase sur lequel circule un courant électrique consommé mesuré par le compteur. Le conducteur de phase est aussi fréquemment utilisé pour transmettre par courants porteurs en ligne des informations de consommation mais aussi des informations relatives à l'état du compteur lui-même. Un défaut de l'organe de coupure peut se traduire au niveau des serveurs du fournisseur d'énergie électrique ou du gestionnaire de réseau par une incertitude quant à l'origine exacte de la panne. La remontée du message d'alarme améliore nettement le diagnostic quant à l'origine de cette panne.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 représente un réseau de compteurs électriques ainsi que les couches des modèles selon lesquels sont mises en œuvre les communications entre les différents éléments constituant le réseau ;
- la figure 2 représente un organe de coupure d'un compteur du réseau et un dispositif de détection inductif pour détecter l'état réel de l'organe de coupure, l'organe de coupure étant dans un état fermé ;
- la figure 3 est une figure analogue à la figure 2, dans laquelle l'organe de coupure est dans un état ouvert ;
- la figure 4 est un schéma électrique du dispositif de détection inductif ;
- la figure 5 représente un signal oscillant produit par le dispositif de la figure 2 ;
- la figure 6 représente un signal oscillant produit par le dispositif de la figure 3 ;
- la figure 7 représente les couches d'un modèle selon lequel la transmission de messages d'alarmes par le compteur est mise en œuvre ;
- la figure 8 représente un message d'alarme décodé transmis par le compteur ;
- la figure 9 représente un dispositif de détection optique du compteur lorsque l'organe de coupure est fermé ;
- la figure 10 représente un dispositif de détection optique du compteur lorsque l'organe de coupure est ouvert.

### DESCRIPTION DETAILLEE DE L'INVENTION

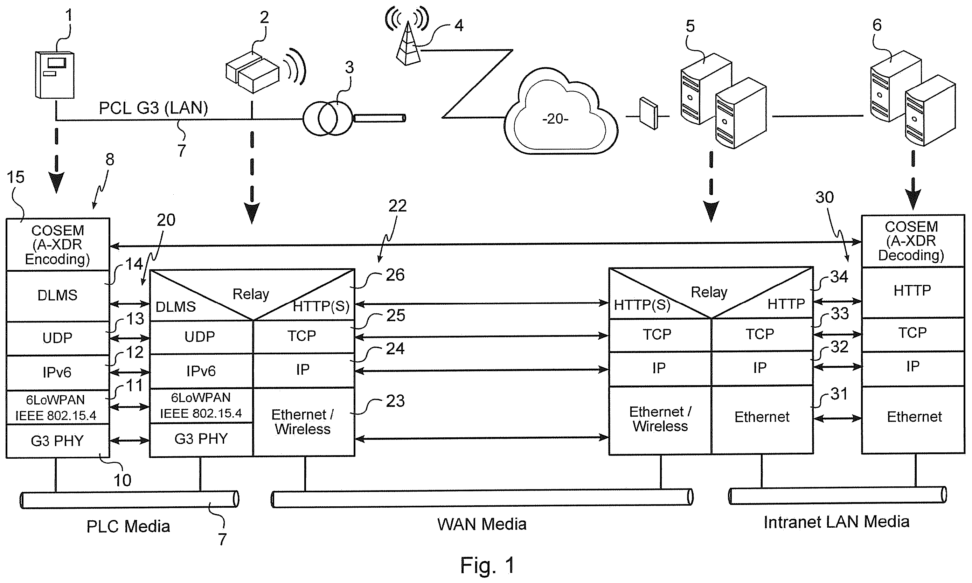

En référence à la figure 1, l'invention est ici mise en œuvre dans un réseau de compteurs d'énergie électrique électroniques intelligents. Le réseau comporte une pluralité de compteurs tels que le compteur 1, un concentrateur de données 2, un poste de transformation Basse Tension/Haute Tension 3, un émetteur/récepteur 4, un premier ensemble de serveurs 5 et un deuxième ensemble de serveurs 6.

Le concentrateur de données 2 est relié à l'ensemble des compteurs 1 par des lignes électriques 7 sur lesquelles est mise en œuvre une communication par courants porteurs en ligne utilisant le protocole G3-PLC (pour « G3-Power Line Communication »).

Un modèle 8 du protocole G3-PLC pour les compteurs 1 repose sur une architecture à six couches comprenant :
- une couche physique 10 de type G3 PHY ;
- une couche de liaison de données 11 de type 6LoWPAN+IEEE 802.15.4 ;
- une couche réseau 12 de type internet IPv6 ;
- une couche transport 13 de type UDP ;
- une couche d'application 14 de type DLMS ;
- une couche d'application 15 de type COSEM.

Les compteurs 1 communiquent avec le concentrateur de données 2 selon un modèle 20 à cinq couches comprenant :
- la couche physique 10 de type G3 PHY ;
- la couche de liaison de données 11 de type 6LoWPAN+IEEE 802.15.4 ;
- la couche réseau 12 de type internet IPv6 ;
- la couche transport 13 de type UDP ;
- la couche d'application 14 de type DLMS.

Le concentrateur de données 2 est de plus relié au premier ensemble de serveurs 5 via le poste de transformation 3, l'émetteur/récepteur 4 et un réseau 20 de type étendu (WAN). Cette communication est réalisée selon un modèle à quatre couches 22 comprenant :
- une couche physique et de liaison 23 de type Ethernet/Wireless ;
- une couche réseau 24 de type IP ;
- une couche transport 25 de type TCP ;
- une couche d'application 26 de type HTTP(S).

Le premier ensemble de serveurs 5 est connecté en outre au deuxième ensemble de serveurs 6. La communication entre le premier ensemble de serveurs 5 et le deuxième ensemble de serveurs 6 est réalisée selon un modèle 30 à quatre couches comprenant :
- une couche physique et de liaison 31 de type Ethernet ;
- une couche réseau 32 de type IP ;
- une couche transport 33 de type TCP ;
- une couche d'application 34 de type HTTP.

On établit ainsi une communication utilisant une couche d'application COSEM entre les compteurs 1 et le deuxième ensemble de serveurs 6.

On s'attache désormais à décrire plus en détail les caractéristiques d'un compteur 1.

Le compteur 1 est destiné à mesurer une énergie électrique qui est fournie par un réseau de distribution situé en amont du compteur 1 et qui est consommée par une installation électrique située en aval du compteur 1. L'énergie électrique est transmise à l'installation électrique par une ligne électrique comprenant un conducteur de phase 40 et un conducteur de neutre auxquels est raccordé le compteur 1.

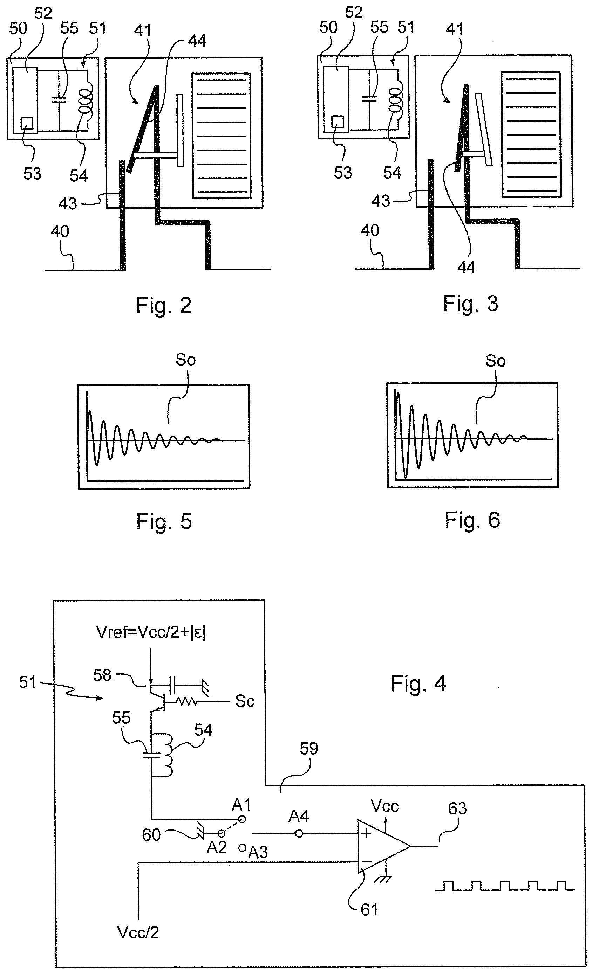

En référence aux figures 2 et 3, un organe de coupure 41 est monté sur le conducteur de phase 40 à l'intérieur du compteur 1. L'organe de coupure 41 permet de sélectivement connecter et déconnecter, à distance, l'installation électrique du réseau de distribution. L'organe de coupure 41 est utilisé pour protéger l'installation électrique en s'ouvrant lorsqu'il est soumis à une surtension accidentelle provenant du réseau de distribution, et en se refermant suite à cette surtension accidentelle sur commande d'un opérateur du distributeur d'énergie électrique. L'organe de coupure 41 est aussi utilisé pour couper ou rétablir à distance l'alimentation de l'installation électrique en cas, par exemple, de résiliation de l'abonnement de l'utilisateur de l'installation électrique ou de non-paiement de l'énergie électrique consommée, sans qu'il soit nécessaire d'envoyer du personnel sur place.

L'état fermé (visible sur la figure 2) et l'état ouvert (visible sur la figure 3) de l'organe de coupure 41 peuvent être commandés par le fournisseur d'énergie électrique (ou par le gestionnaire du réseau) via des données de commande transmises au compteur 1 par le premier ensemble de serveurs 5 ou le deuxième ensemble de serveurs 6 ou bien par le compteur 1 lui-même.

L'organe de coupure 41 comporte un contact fixe métallique 43 et un contact mobile métallique 44. La commande de l'état ouvert de l'organe de coupure 41 est réalisée en éloignant le contact mobile 44 du contact fixe 43, alors que la commande de l'état fermé est réalisée en mettant en contact le contact mobile 44 et le contact fixe 43.

Le compteur 1 comporte un dispositif de détection inductif 50 destiné à détecter si l'organe de coupure 41 est effectivement ouvert ou fermé en fonction de la position du contact mobile 44.

Le dispositif de détection inductif 50 comprend un circuit inductif résonant 51 relié à une unité de traitement 52 comportant un microcontrôleur 53.

Le circuit inductif 51 comprend une bobine 54 montée fixe par rapport à l'organe de coupure 41 et en regard du contact mobile 44 et un condensateur 55 monté en parallèle de la bobine 54.

Lorsque l'organe de coupure 41 est fermé, le contact mobile 44 est rapproché de la bobine 54. La présence du contact mobile 44 à proximité de la bobine 54 modifie de manière importante la valeur d'inductance équivalente aux bornes de la bobine 54.

En référence à la figure 4, la bobine 54 a une extrémité haute reliée à une source de tension Vref = Vcc/2 + |ε| par un transistor 58 commandé par le microcontrôleur 53. La bobine 54 a une extrémité basse reliée à une première borne A1 d'un commutateur 59 ayant une deuxième borne A2 reliée à la masse 60, une troisième borne A3 en haute impédance et une quatrième borne A4 reliée à l'entrée positive d'un comparateur 61 alimenté par Vcc. Le comparateur 61 a une entrée négative reliée à une tension de référence Vcc/2 et une sortie 63 reliée à une entrée du microcontrôleur 53 qui intègre un mécanisme permettant de compter les fronts montants (on pourrait également compter les fronts descendants au lieu des fronts montants) en sortie du comparateur 61 dont la forme d'onde est un signal impulsionnel rectangulaire.

A titre indicatif, les composants utilisés sont typiquement une bobine 54 d'inductance 56µH, un condensateur 55 de capacité 2,2nF, une tension Vcc de 3,3V ; le signal impulsionnel rectangulaire est typiquement un signal à 3,3V.

Le microcontrôleur 53 pilote le transistor 58 entre un état passant et un état bloqué au moyen d'un signal de commande Sc.

L'unité de traitement 52 est agencée pour réaliser périodiquement, c'est-à-dire à des temps tn régulièrement espacés, une opération de détection en mettant en œuvre les étapes suivantes :
- émettre au temps tn pendant une durée typiquement de 2 microsecondes dans le circuit inductif 51 une impulsion de tension Vref en connectant à la masse 60 l'extrémité basse de la bobine 54 grâce au commutateur 59 et en connectant à la source de tension Vref l'extrémité haute de la bobine 54 grâce au transistor 58, puis en connectant, à l'issue des 2 microsecondes, à l'entrée positive du comparateur 61 l'extrémité basse de la bobine 54 grâce au commutateur 59 ;
- détecter un signal oscillant de tension So en sortie du circuit inductif 51 et le comparer à la tension de référence Vcc/2 de manière à obtenir des impulsions rectangulaires lorsque les oscillations ont une amplitude supérieure à Vcc/2 ;
- compter au temps t = tn+t0 le nombre de fronts montants fournis par le circuit inductif 51 ;
- détecter la présence du contact mobile 44 lorsque le circuit inductif 51 livre un nombre de fronts montants M inférieur ou égal à un seuil Mseuil ;
- détecter l'absence du contact mobile 44 lorsque le circuit inductif livre un nombre de fronts montants M supérieur au seuil Mseuil.

Le seuil Mseuil est typiquement fixé à 5.

On comprend que le circuit inductif 51 amortit l'impulsion de tension et fournit un signal oscillant So. Le signal oscillant So en présence du contact mobile 44 (visible sur la figure 5) présente un amortissement plus important que le signal oscillant en l'absence du contact mobile 44 (visible sur la figure 6).

L'état ouvert ou fermé de l'organe de coupure 41 détecté par le dispositif de détection 51 (ou « état réel ») est ensuite comparé à l'état commandé de l'organe de coupure 41. Un message d'alarme est généré si l'état réel est différent de l'état commandé, et ce message est remonté via une communication par courants porteurs en ligne en direction du concentrateur de données 2 et à destination du premier ensemble de serveurs 5 et/ou du deuxième ensemble de serveurs 6.

On détaille désormais le protocole de cette communication en décrivant l'architecture utilisée qui précise le modèle 8 visible sur la figure 1.

Cette communication est réalisée selon une architecture 70 comprenant :
- une couche 71 PLC media (correspondant à la communication sur une ligne électrique par courants porteurs en ligne) ;
- une couche physique 72 de type modulation OFDM ;
- une couche de liaison de données 73 comprenant une sous-couche d'adaptation 74 de type 6LoWPAN (IETF RFC 4944) et une sous-couche MAC 75 de type IEEE 802.15.4 - 2006 ;
- une couche réseau 76 de type internet IPv6 (IETF RFC 2460) ;
- une couche transport 77 de type UDP (IETF RFC 768) ;
- une couche transport 78 de type COSEM Wrapper ;
- une couche d'application 79 comprenant une sous-couche d'application 80 de type COSEM AL (IEC 62056-53) et une sous-couche application 81 de type COSEM AP (IEC 62056-61/62).

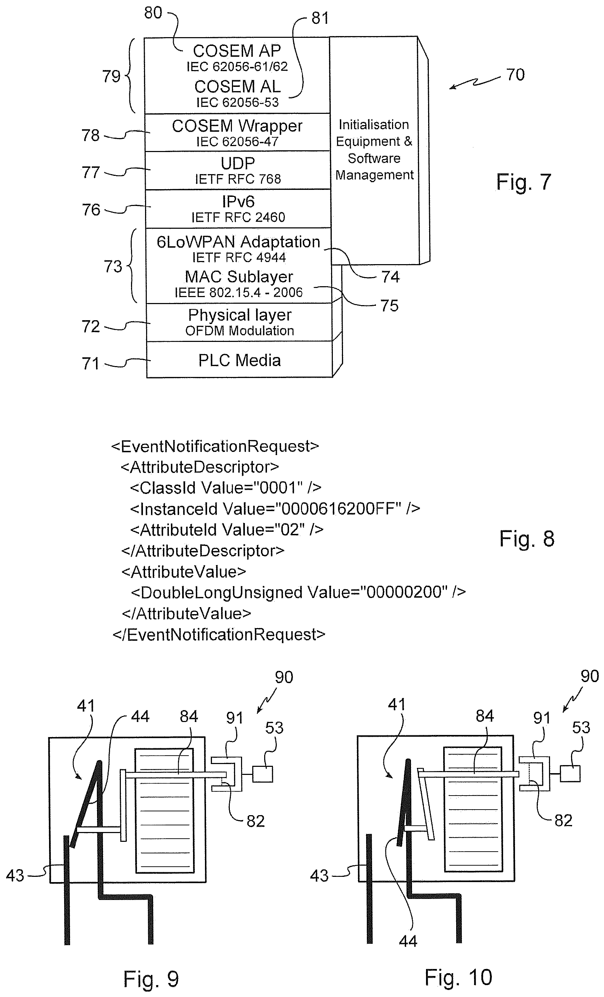

On établit ainsi une communication conforme au standard DLMS/COSEM, dans lequel un message d'alarme envoyé peut être décodé conformément au décodage visible sur la figure 8.

Le code d'alarme correspondant à une incohérence entre l'état commandé ouvert ou fermé et l'état réel de l'organe de coupure 41 correspond à la variable « DoubleLongUnsigned Value » qui prend la valeur 00000200 lorsque l'état commandé et l'état réel sont cohérents et la valeur 00000201 lorsqu'ils ne le sont pas.

Dans un second mode de réalisation, visible sur les figures 9 et 10, le dispositif de détection comprend un capteur optique 90, en l'occurrence un capteur optique à fourche 90 comprenant une fourche 91 dans laquelle un faisceau lumineux 82 est généré. Un bras isolant 84 est monté solidaire du contact mobile 44 de l'organe de coupure 41.

En référence à la figure 9, lorsque l'organe de coupure 41 est dans un état fermé, le bras isolant 84 traverse le faisceau lumineux 82 et interrompt celui-ci. Cette interruption du faisceau lumineux 82 est détectée par le capteur optique à fourche 90 qui détecte ainsi que l'organe de coupure 41 est dans l'état fermé. Une information représentative de cette détection est transmise au microcontrôleur 53.

En référence à la figure 10, lorsque l'organe de coupure 41 est dans un état ouvert, le bras isolant 84 ne traverse pas le faisceau lumineux 82. Le faisceau 82 traverse la fourche d'un bras à l'autre de la fourche 91 et est détecté par le capteur optique à fourche 90 qui détecte ainsi que l'organe de coupure 41 est dans l'état ouvert. Une information représentative de cette détection est transmise au microcontrôleur 53.

Le microcontrôleur 53 compare alors l'état réel de l'organe de coupure 41 avec l'état commandé et, le cas échéant, transmet un message d'alarme en utilisant un protocole similaire à celui précédemment décrit.

Bien entendu, l'invention n'est pas limitée aux modes de réalisation décrits mais englobe toute variante entrant dans le champ de l'invention telle que définie par les revendications.

Le réseau de compteurs représenté sur la figure 1 est un exemple fourni à titre d'illustration et l'invention peut bien sûr être mise en œuvre dans un cadre différent (protocole PRIME au lieu de G3-PLC, absence de concentrateur de données, etc.).

Dans les dispositifs de détection inductif ou optique, on réalise une détection de la position d'un élément cible solidaire d'un contact mobile de l'organe de coupure pour détecter l'état réel de l'organe de coupure. Cet élément cible, qui est ici le contact lui-même pour le dispositif de détection inductif ou bien le bras isolant pour le dispositif de détection optique, pourrait être agencé différemment. On pourrait par exemple utiliser un bras métallique solidaire du contact mobile pour le dispositif de détection inductif.

Bien que l'on ait indiqué que le code d'alarme remonte uniquement l'incohérence entre l'état commandé et l'état réel de l'organe de coupure, il est parfaitement possible d'utiliser un code différent (indiquant par exemple l'état commandé, l'état réel, et la présence ou non d'une incohérence).

## Revendications

1. Procédé de détection d'une incohérence entre un état commandé ouvert ou fermé et un état réel d'un organe de coupure (41) monté sur un conducteur de phase à l'intérieur d'un compteur d'énergie électrique (1), le procédé comportant les étapes :
- de détecter l'état réel de l'organe de coupure (41), la détection de l'état réel de l'organe de coupure (41) consistant à détecter la position d'un élément cible (44, 84) solidaire d'un contact mobile de l'organe de coupure ;
- de comparer l'état réel et l'état commandé ;
- de générer un message d'alarme si l'état réel est différent de l'état commandé ;
- de remonter le message d'alarme en le transmettant via une communication par courants porteurs en ligne,
la communication par courants porteurs en ligne étant conforme à un modèle (8,70) utilisant une couche d'application COSEM.

2. Procédé selon la revendication 1, dans lequel la communication par courants porteurs est conforme à un standard DLMS/COSEM.

3. Procédé selon l'une des revendications précédentes, dans lequel la détection est réalisée par un dispositif de détection (50) comportant un circuit inductif résonant (51) comprenant une bobine (54) montée fixe par rapport à l'organe de coupure en regard d'une trajectoire de l'élément cible.

4. Procédé selon la revendication 3, dans lequel le circuit inductif (51) est relié électriquement à une unité de traitement (52) agencée pour : émettre périodiquement dans le circuit inductif une impulsion de tension, détecter un signal oscillant (So) de tension en sortie du circuit inductif et le comparer à une tension de référence, détecter la position de l'élément cible et donc l'état réel de l'organe de coupure en fonction du nombre d'oscillations supérieures à la tension de référence du signal oscillant (So).

5. Procédé selon la revendication 1, dans lequel la détection est réalisée par un dispositif de détection comportant un capteur optique (90).

6. Procédé selon la revendication 5, dans lequel le capteur optique génère un faisceau lumineux (82) traversé par l'élément cible lorsque l'organe de coupure se trouve dans l'un des états ouvert ou fermé et non traversé par l'élément cible lorsque l'organe de coupure se trouve dans l'autre des états ouvert ou fermé.

## Patentansprüche

1. Detektionsverfahren zur Detektion einer Inkohärenz zwischen einem angeforderten offenen oder geschlossenen Zustand und einem realen Zustand eines Abschaltorgans (41), das auf einem Phasenleiter im Inneren eines Elektroenergiezählers (1) montiert ist, wobei das Verfahren die Schritte umfasst, dass:
- der reale Zustand des Abschaltorgans (41) detektiert wird, wobei die Detektion des realen Zustands des Abschaltorgans (41) darin besteht, dass die Stellung eines fest mit einem beweglichen Kontakt des Abschaltorgans verbundenen Zielelements (44, 84) detektiert wird,
- der reale Zustand und der angeforderte Zustand miteinander verglichen werden;
- eine Alarmmeldung erzeugt wird, wenn sich der reale Zustand von dem angeforderten Zustand unterscheidet;
- die Alarmmeldung zurückverfolgt wird, indem diese über eine Powerline-Kommunikation übertragen wird,
wobei die Powerline-Kommunikation nach einem Modell (8, 70) erfolgt, das eine COSEM-Anwendungsschicht verwendet.

2. Verfahren nach Anspruch 1, wobei die Powerline-Kommunikation nach einem DLMS/COSEM-Standard erfolgt.

3. Verfahren nach einem der vorhergehenden Ansprüche, wobei die Detektion durch eine Detektionsvorrichtung (50) durchgeführt wird, die einen induktiven Resonanzkreis (51) mit einer Spule (54) enthält, die einer Bahn des Zielelements gegenüberliegend fest in Bezug auf das Abschaltorgan montiert ist.

4. Verfahren nach Anspruch 3, wobei der induktive Schaltkreis (51) elektrisch mit einer Verarbeitungseinheit (52) verbunden ist, die dafür ausgelegt ist: in dem induktiven Schaltkreis periodisch einen Spannungsimpuls auszusenden; am Ausgang des induktiven Schaltkreises ein oszillierendes Spannungssignal (So) zu detektieren und dieses mit einer Referenzspannung zu vergleichen; die Stellung des Zielelements, und damit den realen Zustand des Abschaltorgans, in Abhängigkeit von der Anzahl der Schwingungen, die größer als die Referenzspannung des oszillierenden Signals (So) sind, zu detektieren.

5. Verfahren nach Anspruch 1, wobei die Detektion von einer Detektionsvorrichtung durchgeführt wird, die einen optischen Sensor (90) enthält.

6. Verfahren nach Anspruch 5, wobei der optische Sensor einen Lichtstrahl (82) erzeugt, welcher von dem Zielelement durchquert wird, wenn sich das Abschaltorgan in dem einen der Zustände, dem offenen oder dem geschlossenen, befindet, und welcher von dem Zielelement nicht durchquert wird, wenn sich das Abschaltorgan in dem jeweils anderen der Zustände, dem offenen oder dem geschlossenen, befindet.

## Claims

1. A method for detecting an inconsistency between an open or closed controlled state and an actual state of a cut-off member (41) mounted on a phase conductor within an electrical energy meter (1), the method comprising the steps of:
- detecting the actual state of the cut-off member (41), the detection of the actual state of the cut-off member (41) consisting in detecting the position of a target element (44, 84) secured to a moving contact of the cut-off member;
- comparing the actual state and the controlled state;
- generating an alarm message if the actual state is different from the controlled state;
- relaying the alarm message by transmitting it via powerline current telecommunication,
powerline current telecommunication being in accordance with a model (8,70) using a COSEM application layer.

2. The method according to claim 1, wherein the powerline current telecommunication is in accordance with a DLMS/COSEM standard.

3. The method according to any one of the preceding claims, wherein the detection is carried out by a detection device (50) including a resonant inductive circuit (51) comprising a coil (54) mounted fixed relative to the cut-off member facing a trajectory of the target element.

4. The method according to claim 3, wherein the inductive circuit (51) is electrically connected to a processing unit (52) arranged to: periodically emit a voltage pulse in the inductive circuit, detect an oscillating voltage signal (So) at the output of the inductive circuit and compare it with a reference voltage, detect the position of the target element and therefore the actual state of the cut-off member according to the number of oscillations greater than the reference voltage of the oscillating signal (So).

5. The method according to claim 1, wherein the detection is carried out by a detection device comprising an optical sensor (90).

6. The method according to claim 5, wherein the optical sensor generates a light beam (82) through which the target element passes when the cut-off member is in one of the open or closed states and not through which the target element passes when the cut-off member is in the other of the open or closed states.
